# EUROPÄISCHE PATENTSCHRIFT

(11) **EP 0 944 114 B1**
(45) Veröffentlichungstag und Bekanntmachung des Hinweises auf die Patenterteilung: **24.10.2007**
(21) Anmeldenummer: 99104008.0
(22) Anmeldetag: 12.03.1999
(51) Int. Cl.: H01L 21/306

(54) **Verfahren zum nasschemischen pyramidalen Texturätzen von Siliziumoberflächen**
Process for the wet etching of a pyramidal texture on silicium surfaces
Procedé pour l'attaque par voie humide de structures pyramidales sur la surface de silicium

(30) Priorität: 18.03.1998 DE 19811878
(43) Veröffentlichungstag der Anmeldung: 22.09.1999
(73) Patentinhaber: Shell Solar GmbH, 81739 München (DE)
(72) Erfinder: Holdermann, Konstantin, 89362 Offingen (DE)
(74) Vertreter: Rau, Albrecht

(56) Entgegenhaltungen:
- GB-A- 1 250 653
- US-A- 3 909 325
- US-A- 3 940 356
- US-A- 4 137 123

## Beschreibung

Die vorliegende Erfindung betrifft ein Verfahren zum naßchemischen pyramidalen Texturätzen von Siliziumoberflächen.

Eine texturierte Oberfläche reduziert breitrandig die Reflexion des einfallenden Lichtes und erhöht damit die absorbierte Lichtintensität. Bei der Herstellung kristalliner Siliziumsolarzellen führt eine gezielte Strukturierung der Siliziumoberfläche zu einer Steigerung der Solarzellenleistung. Ein derartiges naßchemisches Strukturätzen ist jedoch nicht nur auf die Bearbeitung bzw. Herstellung von Solarzellen begrenzt, sondern ist auch für optische, für elektrochemische, für Bindetektoren bzw. - Sensoren, für Katalysatoren, für Elektroden und dergleichen geeignet.

Bekannte Verfahren zur naßchemischen pyramidalen Strukturätzung von (100)-orientierten Siliziumoberflächen verwenden basische Medien, vorwiegend mit Lösungen von Alkalihydroxiden, Alkalicarbonaten, Ammoniak bzw. Cholin. Lösungen von Hydrazin bzw. Ethylendiamin/Brenzkatechin können auch verwendet werden, sind jedoch aufgrund ihrer Toxizität von Nachteil. Die gängigsten Rezepturen bestehen aus Wasser, Natrium- bzw. Kaliumhydroxid und Alkohol. Der verwendete Alkoholanteil ist hierbei entweder Ethylenglykol oder Isopropanol. Bei den bekannten Verfahren zur naßchemischen Strukturätzung von Silizium geht es jedoch nur um die Erzeugung einer pyramidalen (tetragonalen) Textur schlechthin.

Im Hinblick auf Feinlinienmetallisierung und Anwendung von Dotierlacken oder Photoresist ist jedoch eine Textur mit kleinen Pyramiden wünschenswert.

Ein Verfahren, das auf einer Ethylenglykol haltigen Ätzlösung basiert, ist in EP 0 477 424 A1 beschrieben. Die hier verwendete Rezeptur der Ätzlösung enthält Wasser, Kaliumhydroxid, Ethylenglykol und Silizium. Zusätzlich wird als weitere Komponente Sauerstoff zugefügt. Durch eine Sauerstoffbelüftung der Ätzlösung erhält man nach der naßchemischen Strukturätzung der Siliziumoberfläche reproduzierbar gleichmäßige Pyramiden. Die Pyramidenhöhe kann durch die Belüftungsdauer der Ätzlösung variiert werden. Längerer Sauerstoffeintrag, d.h. stärkere Oxidation des Glykols führt zu kleineren Pyramiden. Auf diese Weise können selbst fertigungstechnisch Pyramidengrößen ≤ 2 µm hergestellt werden. Nachteilig ist hierbei jedoch, daß die auf Ethylenglykol basierende Ätzlösung nicht ad hoc verwendet werden kann, da sie eine vorhergehende Auflösung von Silizium erfordert. Untersuchungen haben gezeigt, daß sich eine anschließend mehrstündige Ruhephase als vorteilhaft für eine Ausbildung glatter (111) Flächen erweist. Eine einfache Zugabe von Silikatlösung führt nicht zum Erfolg.

Verfahren die eine auf Isopropanol basierende Ätzlösung verwenden sind beispielsweise aus US 3,998,659, aus "Uniform Pyramid Formation on Alkaline-etched Polished Monocrystalline (100) Silicon Wafers", Bressers et al, Progress in Photovoltaics, Vol. 4, 435-438 (1996), und aus "Experimental Optimization of an Anisotropic Etching Progress for random Texturization of Silicon Solar Cells", King et al., IEEE 1991, 303-308 bekannt. Im Gegensatz zu der auf Ethylenglykol basierenden Ätzlösung kann eine auf IPA-basierende Ätzlösung sofort zur Texturätzung eingesetzt werden. Diese Ätzlösung kann mit und ohne Silikat verwendet werden. Nachteilig bei dieser Art von Lösung ist jedoch die hohe Verdampfungsrate, aufgrund eines Siedepunktes des Isopropanols von nur 82°C. Damit treten Probleme im Hinblick auf eine gleichförmige Ätzung bzw. auf eine Reproduzierbarkeit der pyramidenförmigen Oberfläche auf. Im Gegensatz zu der auf Ethylenglykol basierenden Ätzlösung neigt die auf IPA basierende Ätzlösung zu großen Pyramiden. Laut Bressers et al können durch Einsatz von Stickstoff zur Verdrängung des gelösten Sauerstoffes während des Ätzvorganges kleine Pyramiden erzielt werden. Hierbei wird jedoch von Laborversuchen berichtet, wobei eine Ätzlösung mit 10 Vol.% Isopropanol, ein Stickstoffluß von 25 l/min und eine Prozeßtemperatur von 80°C verwendet werden. Für einen Fertigungseinsatz in Tanks ist mit einem enormen Isopropanolverbrauch zu rechnen. Dies bringt hohe Kosten mit sich, da die Lebensdauer der Ätzlösung aufgrund einer derartigen hohen Verflüchtigung des IPA gering ist. Dies führt gleichzeitig zu hohen Entsorqungskosten für die gebrauchten Chemikalien.

US 3,909,325 beschreibt eine Ätzlösung für polykristallines Silizium, welche Kaliumhydroxid, Ethylenglykol und Wasser enthält, in die mit Isopropanol benetzte Siliziumscheiben eingebracht werden.

Für die industrielle Herstellung von Solarzellen ist die Gewährleistung einer stetig guten elektrischen Qualität der in großer Stückzahl produzierten Solarzellen wichtig. Eine gleichbleibende gute Qualität in der Ausbildung der Pyramidenstruktur, sowie eine gleichmäßige Strukturierung der gesamten Siliziumoberfläche ist zu gewährleisten. Zudem ist die Möglichkeit die Pyramidengröße in einem gewissen Bereich variieren zu können von Vorteil.

Weder die auf Ethylenglykol basierende Ätzlösung, noch die auf Isopropanol basierende Lösung sind jedoch in der Lage, diese Anforderungen gleichzeitig zufriedenstellend zu erfüllen. Wie oben zusammengefaßt ist zwar die mit Ethylenglykol versetzte wässrig-alkalische Ätzlösung in der Lage Pyramiden mit einer Höhe ≤ 2 µm herzustellen, kann jedoch nicht unmittelbar verwendet werden. Dies ist jedoch gerade für einen industriellen Einsatz von Nachteil. Andererseits kann die Isopropanol haltige Ätzlösung zwar sofort zur Texturätzung eingesetzt werden, neigt jedoch zu großen Pyramiden und erweist sich durch eine hohe Verdampfungsrate des Isopropanols als nachteilig, da dies die Reproduzierbarkeit einer gleichförmigen pyramidalen Textur beeinträchtigt.

Es ist daher die Aufgabe der vorliegenden Erfindung, ein Verfahren zum naßchemischen pyramidalen Texturätzen von Siliziumoberflächen bereitzustellen, das in der Lage ist, - analog der auf Ethylenglykol basierenden Ätzlösung - reproduzierbar kleine (≤ 2 µm) Pyramidengrößen, zu erzeugen, wobei unterschiedliche Pyramidengrößen innerhalb einer gewissen Streuung einstellbar sind, bei gleichzeitig vollständiger Textur der Siliziumoberfläche und gleichzeitiger Reduzierung der Kosten.

Diese Aufgabe wird erfindungsgemäß durch ein Verfahren nach Patentanspruch 7 mittels der Ätzlösung nach Patentanspruch 1 gelöst.

Vorteilhafte Ausgestaltungen der Erfindung ergeben sich aus den Unteransprüchen.

Der zentrale Gedanke der Erfindung besteht darin, daß die zum pyramidalen Strukturieren der Siliziumoberfläche verwendete Ätzlösung sowohl Isopropanol als auch wässrig-alkalische Ethylenglykollösung enthält. Die wässrig-alkalische Ethylenglykollösung wird vorteilhaft mit Sauerstoff umgesetzt, wie zum Beispiel aus EP O 477 424 A1 bekannt. Je größer die umgesetzte Sauerstoffmenge, desto kleiner kann die in der Ätzlösung verwendete Menge der Ethylenglykollösung gewählt werden. Allein durch die gleichzeitige Verwendung von Isopropanol und Ethylenglykol in der Ätzlösung wird überraschenderweise die Aufgabe gelöst und zusätzlich die folgenden Vorteile erzielt. Die Verwendung von bereits vorgeheiztem und damit sauerstoffarmem Wasser wirkt sich dabei - wie auch von Bressers et al beschrieben - zu Ätzbeginn hinsichtlich kleiner Pyramiden unterstützend aus, ist aber nicht unbedingt erforderlich, da durch entsprechende Korrektur beim Glykolanteil ausgleichbar. Vorgewärmtes Isopropanol - auch bei Bressers et al beschrieben - ist aus fertigungstechnischen Gründen problematisch.

Die erfindungsgemäße Ätzlösung ist unmittelbar nach Herstellung texturfähig, d.h. ein Ätzvorgang kann unmittelbar nach dem Herstellen der Lösung durchgeführt werden.

Zudem ist das Ätzergebnis relativ unempfindlich auf die genaue Zusammensetzung der Ätzlösung, d.h. eine präzise Optimierung der einzelnen Lösungsanteile ist nicht notwendig, was insbesondere im Hinblick auf eine industrielle Anwendung von Vorteil ist.

Ein weiterer Vorteil ist die gute Reproduzierbarkeit des Ätzergebnisses. Gleichzeitig ist die Pyramidengröße einstellbar, bei gleichzeitiger vollständiger Textur der Siliziumoberfläche.

Ein weiterer Vorteil ergibt sich dadurch, daß die Ätzlösung der vorliegenden Erfindung den Nachteil einer herkömmlichen nur auf Isopropanol basierenden Ätzlösung, d.h. eine große Verdampfungsrate, in nicht so starkem Maße aufweist. Dies bedeutet, daß die erfindungsgemäße Ätzlösung wesentlich länger zum Ätzen verwendet werden kann als eine herkömmliche nur auf Isopropanol basierende Lösung. Die Ätzlösung muß folglich weniger oft ersetzt werden. Dies reduziert die Kosten, da die Ausfallzeit verringert und somit die Abfallentsorgungsmenge der verwendeten Chemikalien reduziert wird.

Im folgenden wird die Erfindung anhand einiger Ausführungsbeispiele unter Bezugnahme auf die begleitenden Abbildungen beschrieben. Darin zeigt
Fig. 1 eine REM-Aufnahme der geätzten Oberfläche eines ersten Ausführungsbeispiels;
Fig. 2 eine REM-Aufnahme der geätzten Oberfläche eines zweiten Ausführungsbeispiels,
Fig. 3 eine REM-Aufnahme der geätzten Oberfläche eines dritten Ausführungsbeispiels, und
Fig. 4 eine REM-Aufnahme der geätzten Oberfläche eines vierten Ausführungsbeispiels.

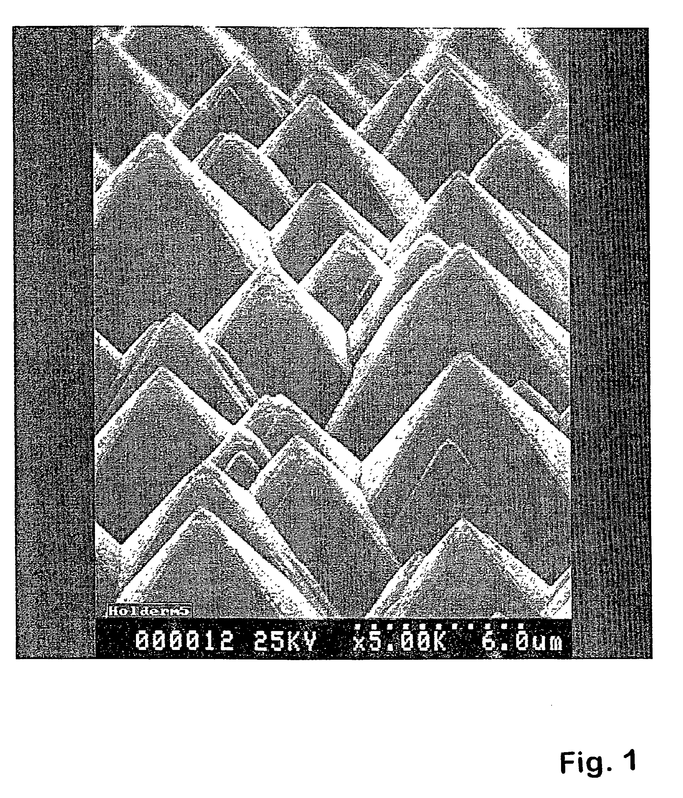

Die erfindungsgemäße Lösung zum Ätzen eines ersten Ausführungsbeispiels setzt sich zusammen aus 15 l Wasser, 300 ml 50%-iger Natriumhydroxidlösung, 400 ml gelöstem Silikat, 600 ml Isopropanol und 15 ml wässrig-alkalischer Ethylenglykollösung. Die Temperatur der Ätzlösung wurde auf 78°C eingestellt und die Silizium-Wafer wurden für 20 Minuten in diese Lösung eingetaucht. Die hier verwendeten Siliziumscheiben weisen eine Größe von bis zu 6 Zoll auf, sind bis zu 120um dünn geätzt und haben vor dem Ätzvorgang spiegelnde Oberflächen. Eine REM-Aufnahme der Oberfläche des mit dieser Lösung geätzten Siliziums ist in Fig. 1 dargestellt, und zeigt eine gleichmäßige und vollständige Pyramidenstruktur mit einer Pyramidenhöhe von etwa 6 µm.

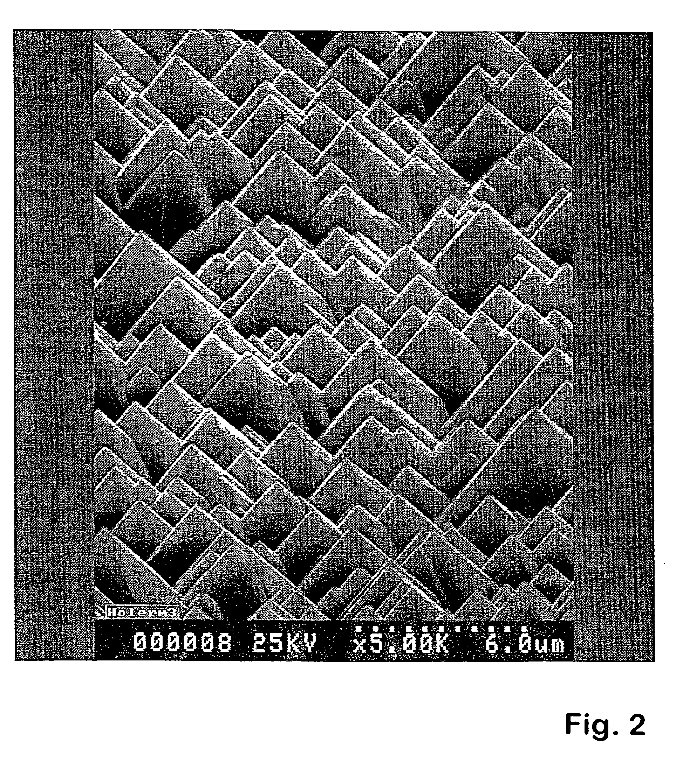

In einem zweiten Ausführungsbeispiel wurde eine Ätzlösung verwendet, die aus 15 l Wasser, 600 ml 50%-iger Natriumhydroxidlösung, 300 ml Isopropanol und 30 ml wässrig-alkalischer Ethylenglykollösung besteht. Silikat wurde nicht beigemengt. Diese Lösung wurde auf eine Temperatur von 78°C erwärmt, und die Silizium-Wafer wurden 10 Minuten lang in diese Lösung eingetaucht. Die Oberfläche des mit dieser Ätzlösung strukturierten Silizium-Wafers ist in Fig. 2 dargestellt. Es ist eine gleichmäßige pyramidale Siliziumoberfläche zu sehen, mit einer Pyramidenhöhe von ungefähr 3 µm.

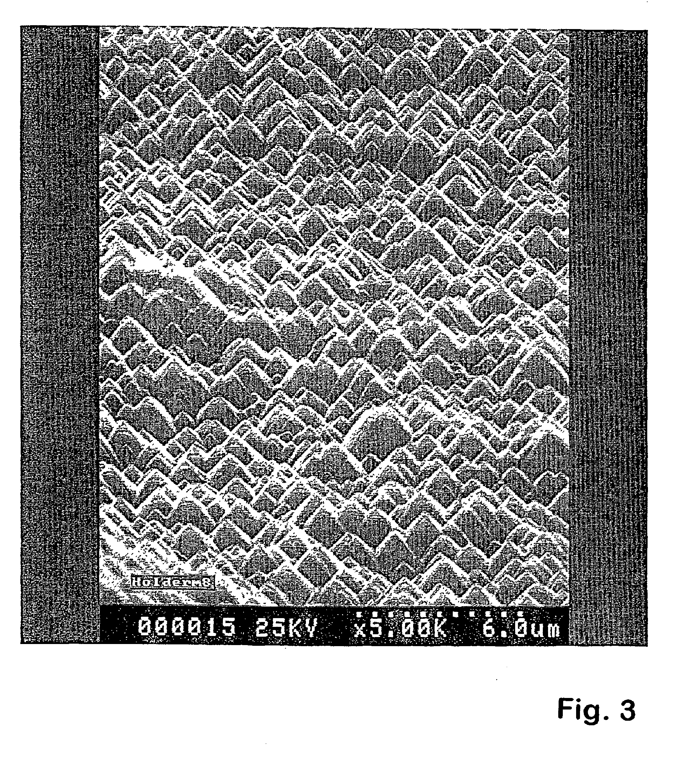

In einem weiteren Ausführungsbeispiel wurde eine Ätzlösung verwendet, die 15 l Wasser, 50 ml 50%-ige Natriumhydroxidlösung, 100 ml Isopropanol und 50 ml wässrig-alkalische Ethylenglykollösung enthält, ebenfalls ohne Zusatz von Silikat. Auch diese Lösung wurde auf eine Temperatur von 78°C erwärmt, und ein anschließender Ätzprozess wurde 5 Minuten lang durchgeführt. Die mit dieser Lösung strukturierte Siliziumoberfläche ist in der in Fig. 3 gezeigten REM-Aufnahme dargestellt. Auch hier ist eine gleichmäßige und vollständige pyramidale Struktur zu erkennen. Die Pyramiden weisen eine Höhe kleiner als 1,5 µm auf.

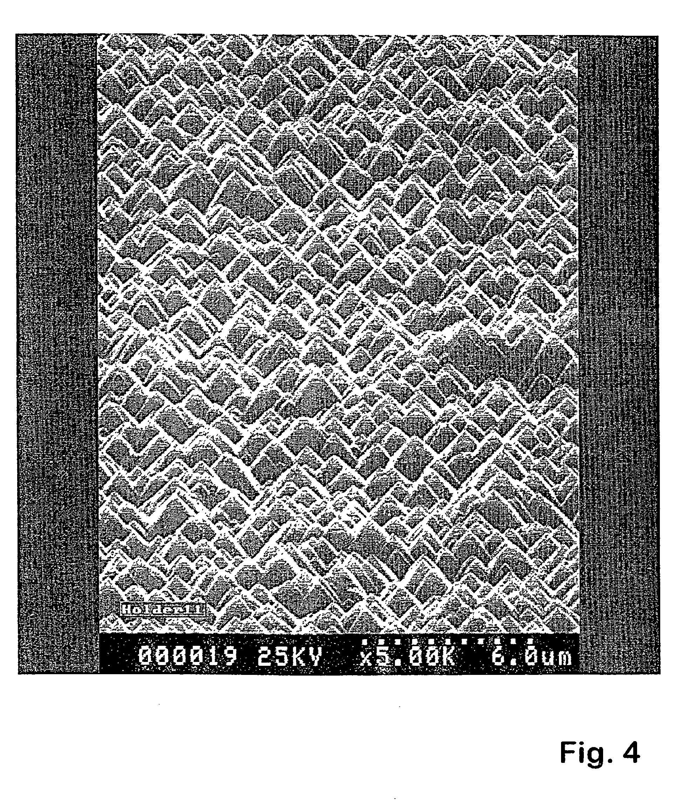

Weitere Siliziumproben wurde mit einer Ätzlösung geätzt, die 15 l Wasser, 400 ml 50%-ige Natriumhydroxidlösung, 400 ml Isopropanol und 25 ml wässrig-alkalische Ethylenglykollösung (ohne Zusatz von Silikat) enthält. Diese Lösung wurde auf eine Temperatur von 60°C erhitzt und die Siliziumprobe wurde anschließend 10 Minuten in dieser Lösung geätzt. Das Ergebnis ist in Fig. 4 zu sehen. Auch hier weist die Oberfläche eine pyramidale Struktur auf, mit einer Pyramidenhöhe von ungefähr 1,5 µm.

Aus den Ausführungsbeispielen 1 bis 3 geht hervor, wie mit steigendem Glykolanteil die Pyramidengröße abnimmt. Im 4. Ausführungsbeispiel wird von einer stärker belüfteten wäßrigalkalischen Ethylenglykollösung ausgegangen, weswegen hier der Anteil verkleinert werden konnte, um wie in Beispiel 3 Pyramidengrößen von ≤ 1,5 Am zu erzeugen.

Jede in den Ausführungsbeispielen verwendete Ätzlösung kann unmittelbar nach der Herstellung verwendet werden, d.h. die Ätzlösung ist unmittelbar texturfähig. Ein langwieriges Auflösen von Silizium, wie das bei bekannten auf Ethylenglykol basierenden Lösungen notwendig ist, entfällt.

Ein Zusatz von Silikat ist nicht erforderlich, wirkt sich jedoch auch nicht störend aus. Dies geht beispielsweise aus dem ersten Ausführungsbeispiel hervor, bei dem 400 ml gelöstes Silikat in der Ätzlösung enthalten ist. Auch in diesem Ausführungsbeispiel wurde eine gleichmäßige vollständige pyramidale Strukturierung erzielt.

Die vorgeschlagene Ätzlösung enthält einen nur geringen Isopropanolgehalt von vorzugsweise ca. 2 bis 5 Vol.%, um den Isopropanolverbrauch zu minimieren.

Zusätzlich geht aus den oben beschriebenen Ausführungsbeispielen hervor, daß es auf eine präzise Optimierung der einzelnen Lösungsanteile nicht ankommt, da unterschiedliche Konzentrationen unterschiedlicher Lösungsanteile eine zufriedenstellende Textur der Siliziumoberfläche ermöglichen. D.h. das Prozeßfenster der erfindungsgemäßen Ätzlösung weist eine erhebliche Größe auf, was insbesondere für einen industriellen Strukturierungsprozeß von Vorteil ist. Zudem kann, wie aus den REM-Aufnahmen der einzelnen Ausführungsbeispiele ersichtlich, die Pyramidengröße durch eine unterschiedliche Zusammensetzung der Lösung variiert werden, bei gleichbleibender zuverlässiger und vollständiger Strukturierung. Die Prozeßtemperatur wird hierbei zwischen 60°C und 80°C eingestelllt, und die Ätzzeit beträgt je nach gewünschter Pyramidengröße zwischen 5 Minuten und 20 Minuten.

Weiterhin ist zu erwähnen, daß nativ gewachsenes Oxid, das sich bei wochenlangem Stehen der zu ätzenden Siliziumscheibe bildet, sich genauso wenig störend auswirkt, wie etwa eine unterschiedliche Siliziumoberflächenbeschaffenheit (z.B. rauh oder poliert).

Um einen möglichen Einfluß von nativ gewachsenem Oxid zu untersuchen, wurden Wafer, die zuvor mehrere Wochen in der Raumluft standen, trocken in die Ätzlösung eingetaucht, und Wafer, die vor dem Ätzschritt ca. 60 Minuten im Wasserspülbecken standen, wurden naß in die Ätzlösung eingetaucht. Nativ gewachsenes Oxid ergibt in beiden Fällen keine Störung der Texturätzung. Ein vorheriger Flußsäure-Dip zur Entfernung dieses Oxids ist nicht nötig.

Ein Verbrauch der Ätzlösung kann durch Zugabe der erforderlichen Medien ausgeglichen werden, wobei diese nicht extra aufgeheizt werden müssen, um beispielsweise gelösten Sauerstoff zu minimieren.

Die erfindungsgemäße Ätzlösung eignet sich für verschiedene Formen der Medienbewegung. Möglich sind Bubbler, Rührer, Hubvorrichtungen oder ein Umpumpen der Lösung, sowie eine Kombination derartiger Vorrichtungen.

## Patentansprüche

1. Ätzlösung für nasschemisches pyramidales Texturätzen von Siliziumoberflächen, bestehend aus zumindest
a) Wasser,
b) einem basischen Reagenz und gleichzeitig
c) Isopropanol und
d) einer wässrig-alkalischen Ethylenglykollösung, **dadurch gekennzeichnet, dass**
e) der in der Ätzlösung enthaltene Isopropanolanteil größer als der Ethylenglykolanteil ist.

2. Ätzlösung nach Anspruch 1, **dadurch gekennzeichnet, dass** der Ätzlösung Silikat beigemengt ist.

3. Ätzlösung nach Anspruch 1 oder 2, **dadurch gekennzeichnet, dass** die Ätzlösung einen Isopropanolgehalt von 0,5 bis 5 Vol.% aufweist.

4. Ätzlösung nach einem der Ansprüche 1 bis 3, **dadurch gekennzeichnet, dass** das basische Reagenz Natrium- bzw. Kaliumhydroxid ist.

5. Ätzlösung nach einem der Ansprüche 1 bis 4, **dadurch gekennzeichnet, dass** die wässrig-allcalische Ethylenglykollösung mit Sauerstoff umgesetzt ist.

6. Ätzlösung nach einem der Ansprüche 1 bis 5, **dadurch gekennzeichnet, dass** die Ätzlösung eine Temperatur zwischen 60°C und 80°C hat.

7. Verfahren zum nasschemischen pyramidalen Texturätzen von Siliziumoberflächen, umfassend die folgenden Schritte:
a) Bereitstellen einer Ätzlösung gemäß einem der Ansprüche 1 bis 6,
b) Bereitstellen eines Silizium-Wafers,
c) Eintauchen des Silizium-Wafers in die Ätzlösung.

8. Verfahren nach Anspruch 7, **dadurch gekennzeichnet, dass** die Ätzzeit 5 bis 20 Minuten beträgt.

## Claims

1. An etching solution for the wet chemical pyramidal texture etching of silicon surfaces, comprising at least
a) water,
b) an alkaline reagent and simultaneously
c) isopropanol and
d) an aqueous alkaline ethylene glycol solution, wherein
e) the proportion of isopropanol present in the etching solution is greater than the proportion of ethylene glycol.

2. Etching solution according to claim 1,
wherein silicate is added to the etching solution.

3. Etching solution according to claim 1 or 2,
wherein the etching solution contains 0.5 to 5 vol.% isopropanol.

4. Etching solution according to any of claims 1 to 3,
wherein the alkaline reagent is sodium or potassium hydroxide.

5. Etching solution according to any of claims 1 to 4,
wherein the aqueous alkaline ethylene glycol solution is reacted with oxygen.

6. Etching solution according to any of claims 1 to 5,
wherein the etching solution has a temperature between 60°C and 80°C.

7. A method for the wet chemical pyramidal texture etching of silicon surfaces, comprising the following steps:
a) Providing an etching solution according to claims 1 to 6,
b) providing a silicon wafer,
c) immersing the silicon wafer into the etching solution.

8. A method according to claim 7,
wherein the etching period is 5 to 20 minutes.

## Revendications

1. Solution de gravure pour la gravure texturation chimique par voie humide pyramidale de surfaces de silicium, composée au moins
a) d'eau,
b) d'un réactif basique et simultanément
c) d'isopropanol et
d) d'une solution d'éthylène glycol alcalino-aqueuse,
**caractérisée en ce que**
e) la proportion d'isopropanol contenue dans la solution de gravure est supérieure à la proportion d'éthylène glycol.

2. Solution de gravure selon la revendication 1, **caractérisée en ce que** la solution de gravure est additionnée de silicate.

3. Solution de gravure selon la revendication 1 ou 2, **caractérisée en ce que** la solution de gravure présente une teneur en isopropanol de 0,5 à 5 % en volume.

4. Solution de gravure selon l'une des revendications 1 à 3, **caractérisée en ce que** le réactif basique est l'hydroxyde de sodium ou de potassium.

5. Solution de gravure selon l'une des revendications 1 à 4, **caractérisée en ce que** la solution d'éthylène glycol alcalino-aqueuse est convertie avec de l'oxygène.

6. Solution de gravure selon l'une des revendications 1 à 5, **caractérisée en ce que** la solution de gravure a une température entre 60°C et 80°C.

7. Procédé pour la gravure texturation chimique par voie humide pyramidale de surfaces de silicium, comprenant les étapes suivantes :
a) mise à disposition d'une solution de gravure selon l'une des revendications 1 à 6,
b) mise à disposition d'un wafer de silicium,
c) immersion du wafer de silicium dans la solution de gravure.

8. Procédé selon la revendication 7, **caractérisé en ce que** le temps de gravure est de 5 à 20 minutes.
